# EUROPÄISCHE PATENTANMELDUNG

(11) **EP 2 651 183 A2**
(43) Veröffentlichungstag der Anmeldung: **16.10.2013**
(21) Anmeldenummer: 13001317.0
(22) Anmeldetag: 15.03.2013
(51) Int. Cl.: H05B 6/72, G01N 1/44, B01L 9/00

(54) **Probenhalter zum Aufheizen einer Probe durch Strahlung aus einer Strahlungsquelle**

(30) Priorität: 13.04.2012 DE 102012007468
(71) Anmelder: Forschungszentrum Jülich GmbH, 52425 Jülich (DE)
(72) Erfinder: Dittmann, Regina, 52477 Alsdorf (DE); Wicklein, Sebastian, 52457 Aldenhoven (DE)

(57) **Zusammenfassung**

Die Erfindung betrifft einen Probenhalter zum Aufheizen einer Probe durch Strahlung aus einer Strahlungsquelle. Dieser umfasst einen auf der Rückseite der Probe anzuordnenden Absorber für die Strahlung, eine zwischen dem Absorber und der Probe anzuordnende metallische Wärmebrücke und Mittel zur Ausübung einer Normalkraft auf die Stapelung aus Probe, Wärmebrücke und Absorber. Erfindungsgemäß umfasst der Probenhalter einen Rahmen mit einer Aussparung für die Probe, wobei eine Mehrzahl von Vorsprüngen als Auflagepunkte für die Vorderseite der Probe in das Profil der Aussparung hineinragen, und es sind Mittel zur Ausübung einer Normalkraft zwischen dem Absorber und dem Rahmen vorgesehen. Durch die sehr kleine Auflagefläche zwischen Probe und Rahmen wird die Ausbildung eines Temperaturgefälles zwischen den Bereichen, in denen sich Probe und Rahmen berühren, und den restlichen Bereichen der Probe unterdrückt. Dadurch wird vermieden, dass das Temperaturgefälle die Probe während des Aufheizens und insbesondere bei einem schnellen Abschrecken nach dem Aufheizen zum Reißen bringt.

## Beschreibung

Die Erfindung betrifft einen Probenhalter zum Aufheizen einer Probe durch Strahlung aus einer Strahlungsquelle.

### Stand der Technik

Oxidische Dünnschichten sind technologisch wichtig für die gesamte Oxid-basierte Elektronik, wie beispielsweise die Realisierung von resistiv schaltenden Speicherelementen. Damit diese Schichten auf geeigneten Substrat-Proben aufgebracht werden können, ist es vielfach erforderlich, die Probe auf Temperaturen über 1000 °C aufzuheizen und zugleich einer oxidierenden Atmosphäre auszusetzen. Diese Umgebungsbedingungen sind sehr aggressiv und zerstören die üblicherweise als Probenheizungen verwendeten glühenden Filamente sofort.

Aus (S. Ohashi, M. Lippmaa, N. Nakagawa, H. Nagasawa, H. Koinuma, M. Kawasaki, "Compact laser molecular beam epitaxy system using laser heating of substrate for oxide film growth", Review of Scientific Instruments 70, 178-183 (1999)) ist bekannt, die Probe über eine Wärmebrücke thermisch an einen Absorber anzukoppeln und diesen Absorber durch einen von außen in die Vakuumkammer eingestrahlten Laserstrahl zu heizen.

Nachteilig neigen Proben, die auf diese Weise aufgeheizt wurden, mit steigender Temperatur zunehmend dazu, zu reißen, da die punktuelle Erhitzung des Substrats durch den Laserstrahl thermische Spannungen im Substrat erzeugt. Diese Tendenz verstärkt sich, wenn die Proben schneller geheizt oder nach dem Heizen schneller abgekühlt werden. Darüber hinaus ist das direkte Erhitzen mittels Laser nur dann möglich, wenn das Substrat auch die emittierte Wellenlänge des Lasers absorbieren kann.

### Aufgabe und Lösung

Es ist daher die Aufgabe der Erfindung, das Heizen von Proben mit Strahlung aus einer Strahlungsquelle dahingehend zu verbessern, dass die Proben nach dem Prozess mit höherer Wahrscheinlichkeit intakt sind und auch Substrate mit geringem Absorptionskoeffizienten erhitzt werden können.

Diese Aufgabe wird erfindungsgemäß gelöst durch einen Probenhalter gemäß Hauptanspruch. Weitere vorteilhafte Ausgestaltungen ergeben sich aus den darauf rückbezogenen Unteransprüchen.

### Gegenstand der Erfindung

Im Rahmen der Erfindung wurde ein Probenhalter zum Aufheizen einer Probe durch Strahlung aus einer Strahlungsquelle entwickelt. Dieser umfasst einen auf der Rückseite der Probe anzuordnenden Absorber für die Strahlung, eine zwischen dem Absorber und der Probe anzuordnende metallische Wärmebrücke und Mittel zur Ausübung einer Normalkraft auf die Stapelung aus Probe, Wärmebrücke und Absorber.

Als Absorber ist jedes Material geeignet, das die verwendete Strahlung effektiv absorbiert und gleichzeitig bei den angestrebten Temperaturen und Umgebungsbedingungen stabil bleibt. Die Strahlungsquelle kann insbesondere ein Laser sein. Für Temperaturen um 1300 °C in oxidierender Atmosphäre ist insbesondere Nickeloxid (NiO) geeignet, um Laserlicht eines Diodenlasers (Wellenlänge 938 nm) zu absorbieren. Der Probenhalter funktioniert aber auch völlig analog, wenn er mit einem Widerstandsheizer beheizt wird, der ebenfalls Infrarotlicht emittiert. Der Absorber muss dann nicht speziell auf eine Laserwellenlänge sensitiv sein.

Die metallische Wärmebrücke ist duktil. Wird die Normalkraft ausgeübt, passt sie sich den mikroskopischen Oberflächenrauhigkeiten von Probe und Absorber an und stellt so einen optimalen Wärmekontakt her. Ohne Wärmebrücke würden diese Rauhigkeiten mikroskopische, stark wärmeisolierende Leerräume zwischen Probe und Absorber schaffen. Als Materialien für die Wärmebrücke sind insbesondere Gold, Platin oder eine Silber-Palladium-Legierung geeignet.

Erfindungsgemäß umfasst der Probenhalter einen Rahmen mit einer Aussparung für die Probe, wobei eine Mehrzahl von Vorsprüngen als Auflagepunkte für die Vorderseite der Probe in das Profil der Aussparung hineinragen, und es sind Mittel zur Ausübung einer Normalkraft zwischen dem Absorber und dem Rahmen vorgesehen.

Es wurde erkannt, dass hierdurch die Ableitung der über den Absorber und die Wärmebrücke in die Probe eingekoppelten Wärme aus der Vorderseite der Probe minimiert werden kann. Die Mittel zur Ausübung einer Normalkraft auf die Stapelung aus Probe, Wärmebrücke und Absorber müssen zwangsläufig auch die Vorderseite der Probe berühren. Indem die Gesamtfläche dieses mechanischen Kontakts erfindungsgemäß minimiert wird, wird zum Einen ein größerer Teil der insgesamt in den Absorber eingekoppelten Laserenergie genutzt, so dass die zu beschichtende Vorderseite der Probe auf eine höhere Temperatur gebracht werden kann. Zum Anderen wird die Ausbildung eines Temperaturgefälles zwischen den Bereichen, in denen die Normalkraft auf die Vorderseite der Probe einwirkt, und den restlichen Bereichen der Probe unterdrückt. Dadurch wird vermieden, dass das Temperaturgefälle die Probe während des Aufheizens und insbesondere bei einem schnellen Abschrecken nach dem Aufheizen zum Reißen bringt.

Zugleich wird die Probe nur an den wenigen Punkten, an denen sie mit ihrer Vorderseite auf den Vorsprüngen aufliegt, mit ihrer Rückseite gegen die Wärmebrücke gedrückt. Dadurch wird begünstigt, dass sich die Probe gegen die Wärmebrücke bewegen kann, um die durch unterschiedliche thermische Ausdehnungskoeffizienten verursachten Spannungen zwischen Probe und Wärmebrücke abzubauen. Auch diese Spannungen können die Probe zum Reißen bringen.

Typischerweise liegen die vier Ecken der Probe auf einer Fläche von ca. 0.15 - 0.2 mm² pro Ecke auf den Vorsprüngen auf. Das Substrat hat also nur auf insgesamt - 0.8 mm² Kontakt mit den Vorsprüngen.

Die Normalkraft muss nicht unmittelbar auf den Absorber ausgeübt werden. Sie kann beispielsweise auch über ein dem Absorber vorgeschaltetes Fenster auf den Absorber vermittelt werden.

Vorteilhaft lässt das Profil der Aussparung eine Bewegung der Probe infolge der durch das Aufheizen bewirkten thermischen Ausdehnung zu. Dadurch wird vermieden, dass die thermische Ausdehnung die Probe unter extreme Druckspannung setzt und schließlich zum Zerreißen bringt. Hierzu kann insbesondere das Profil der Aussparung rechteckig und in den Ecken jeweils über das Rechteck hinaus fortgesetzt sein, und es können weitere Vorsprünge zur Führung der Kanten der Probe in das Profil der Aussparung hineinragen. Dadurch wird verhindert, dass sich die Probe bei der durch thermische Ausdehnung bewirkten Bewegung in der Aussparung verkantet und in dieser verkanteten Position zum Zerreißen gebracht wird. Das Profil der Aussparung kann beispielsweise durch Fräsen oder Bohren über das Rechteck hinaus fortgesetzt sein.

In einer besonders vorteilhaften Ausgestaltung der Erfindung ist ein zweiter Rahmen vorgesehen, dessen Randbereich die Normalkraft auf den Absorber auszuüben vermag und durch dessen Inneres der Laserstrahl auf den Absorber eingestrahlt werden kann. Dabei können insbesondere Mittel zur Ausübung eines Pressdrucks der beiden Rahmen gegeneinander, beispielsweise eine Verschraubung, vorgesehen sein. Der Absorber kann dann gleichmäßig mit der Normalkraft belastet werden, so dass der Druck auf ihn geringer ist als der Druck auf die Probe.

Der zweite Rahmen lässt sich mechanisch vorteilhaft so ausgestalten, dass er in UHV-Manipulationssysteme und in die Halterungen von im UHV befindlichen Bearbeitungsstationen, beispielsweise Aufdampfapparaturen, einsetzbar ist. Sind die beiden Rahmen miteinander verbunden, wird dadurch der Probenhalter insgesamt im Vakuum manipulierbar. Dabei kann die Geometrie des ersten Rahmens sich allein nach den Abmessungen der Probe richten, während die Geometrie des zweiten Rahmens allein nach den Anforderungen der Manipulierbarkeit richtet. So können beispielsweise mehrere verschiedene erste Rahmen für unterschiedliche Probengrößen mit ein und demselben zweiten Rahmen kombiniert werden.

Vorteilhaft ist auf der der Probe abgewandten Seite des Absorbers ein für den Laserstrahl transparentes Fenster angeordnet. Der Absorber wird beim Aufheizen am heißesten. Falls er bei der hohen Temperatur flüchtige Bestandteile absondert, könnten sich diese in der Vakuumkammer verteilen und die Probe verschmutzen. Das Fenster hält diese flüchtigen Bestandteile zurück.

In einer besonders vorteilhaften Ausgestaltung der Erfindung bestehen der oder die Rahmen aus einer metallischen Legierung, die bei Temperaturen oberhalb von 800 °C eine keramische Oxidschicht an ihrer Oberfläche auszubilden vermag.

Es wurde erkannt, dass die Verwendung einer derartigen Legierung die jeweiligen Vorteile von Metall und Keramik miteinander kombiniert. Das Metall im Inneren ist duktil; wird es beim Manipulieren in der Vakuumkammer stark mechanisch beansprucht, beispielsweise durch Anstoßen an der Kammerwand, verformt es sich plastisch. Wären die Rahmen voll keramisch, würden sie in dieser Situation sofort zerbrechen. Zudem ist die metallische Legierung leicht zu bearbeiten. Die keramische Oxidschicht an der Oberfläche hat andererseits den Vorteil, dass sie bei hoher Temperatur in oxidierender Atmosphäre chemisch inert ist und keine flüchtigen metallischen Bestandteile absondert, die die Oberfläche der Probe verschmutzen könnten. Insbesondere Nickel als wesentlicher Bestandteil vieler hochwarmfester Stähle ist sehr leicht flüchtig. Da die keramische Schicht sich automatisch beim ersten Hochtemperatureinsatz der Legierung bildet, heilt sie sich zudem selbst, wenn sie im Gebrauch mechanisch beschädigt wird.

Vorteilhaft enthält die metallische Legierung Aluminium und/oder Zirkon. Zirkon bildet bei hoher Temperatur in Verbindung mit weiteren Komponenten wie Aluminium, Chrom und Yttrium stabilisierte keramische Oxide, die eine gasdichte Schicht bilden und das Ausgasen metallischer Bestandteile aus dem Inneren der Legierung verhindern. Das Zirkon stabilisiert das Aluminiumoxid außerdem mechanisch. Aluminium bildet beim Hochtemperatureinsatz eine gasdichte keramische Al₂O₃-Schicht an der Oberfläche, die sowohl eine weitere Oxidation der Legierung als auch ein Abdampfen flüchtiger Bestandteile der Legierung verhindert und die Kontamination der Probe verhindert.

### Spezieller Beschreibuncisteil

Nachfolgend wird der Gegenstand der Erfindung anhand von Figuren erläutert, ohne dass der Gegenstand der Erfindung hierdurch beschränkt wird. Es ist gezeigt:
- Figur 1:: Ausführungsbeispiel des erfindungsgemäßen Probenhalters, dargestellt als Explosionszeichnung (Teilbild a) sowie im verschraubten Zustand schräg von oben (Teilbild b) und schräg von unten (Teilbild c) gesehen.
- Figur 2:: Test der Effektivität verschiedener Materialien als Wärmebrücke.

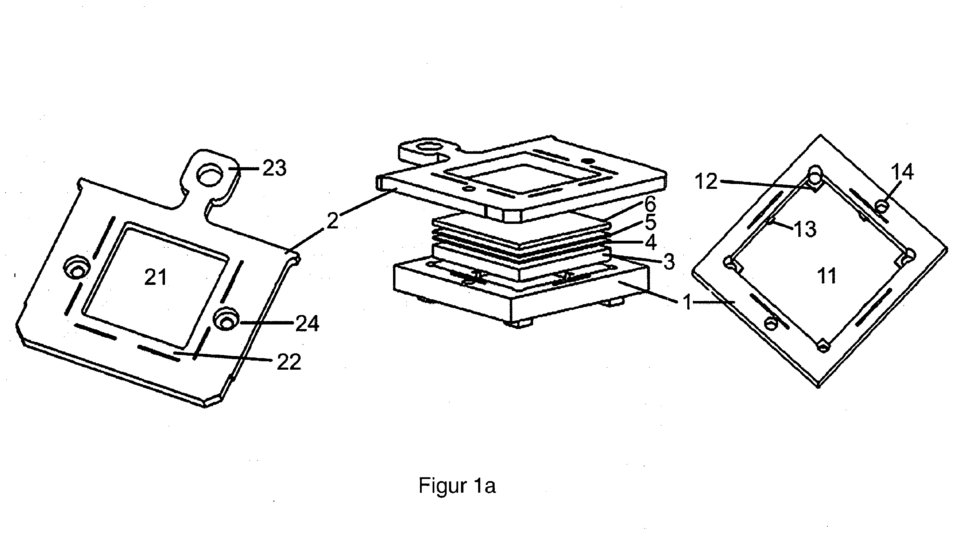

Figur 1a zeigt ein Ausführungsbeispiel des erfindungsgemäßen Probenhalters in Explosionsdarstellung. Der Halter ist aus zwei Rahmen 1 und 2 zusammengesetzt, die beide aus der von der Fa. Haynes International vertriebenen Legierung "214®Alloy" bestehen. Der Rahmen 1 weist eine rechteckige Aussparung 11 für die Probe auf, die etwas größer ist als die Probe. Die Ecken der Aussparung 11 sind jeweils über das Rechteckprofil hinaus fortgesetzt, indem sie nach außen hin aufgefräst wurden. In das Profil der Aussparung 11 ragen Vorsprünge 12 hinein, die als Auflagen für die Vorderseite der Probe 3 dienen. Weiterhin ragen in die Aussparung 11 weitere Vorsprünge 13 zur Führung der Kanten der Probe 3 hinein. Die Probe 3 ist ein quadratisches SrTiO₃-Substrat mit einer Kantenlänge von 10 mm und einer Dicke von 1 mm.

An die Probe 3 grenzt eine Edelmetallfolie 4 als Wärmebrücke an. An diese Wärmebrücke grenzt der Absorber 5 aus NiO an. Dieser Absorber wurde hergestellt, indem eine Nickel-Folie bei 950 °C oxidiert wurde. Dadurch bildete sich an der Oberfläche der Folie eine NiO-Schicht, die dick genug ist, um das Licht eines Diodenlasers effektiv zu absorbieren.

Zwischen dem Absorber 5 und dem zweiten Rahmen 2 ist ein Saphirfenster 6 angeordnet. Dieses hält eventuell sublimierende Komponenten aus dem Absorber 5 und der Wärmebrücke 4 zurück und verhindert so, dass sich diese auf der Probe 3 niederschlagen.

Der zweite Rahmen 2 weist eine rechteckige Aussparung 21 auf, die etwas kleiner ist als das Saphirfenster 6. Durch die Aussparung 21 hindurch kann das Laserlicht in das Saphirfenster 6 und schließlich in den Absorber 5 eintreten. Sind die beiden Rahmen 1 und 2 verbunden, drückt der Randbereich 22 des Rahmens 2 auf das Saphirfenster 6 und übt vermittelt durch dieses inkompressible Fenster die Normalkraft auf den Absorber 5 aus. Der zweite Rahmen 2 weist zusätzlich eine Lasche 23 auf. An dieser Lasche lässt sich die gesamte Einheit aus den beiden Rahmen 1 und 2, Probe 3, Wärmebrücke 4, Absorber 5 und Fenster 6 mit UHV-Manipulatoren greifen und transferieren. Der Probenhalter kann in jedes Dünnschicht-Depositionssystem (PLD, MBE, Sputtern) und jedes Analyseinstrument eingesetzt werden, das den Standardhalter der Fa. Omicron NanoTechnology verwendet. Der Rahmen 2 enthält Schraublöcher 24, der Rahmen 1 enthält M1-Gewinde 14. Somit lassen sich die beiden Rahmen miteinander verschrauben.

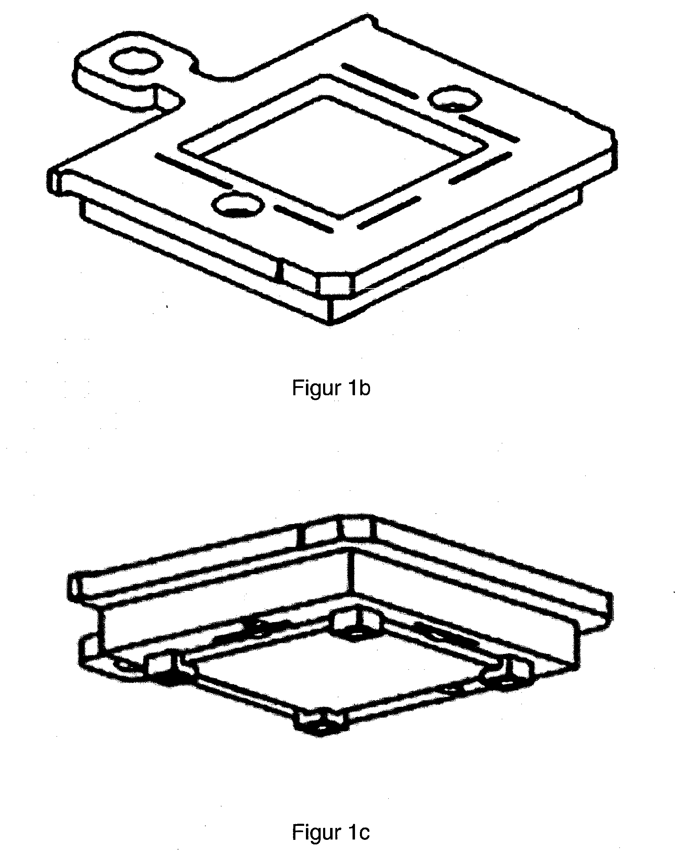

Figur 1 b zeigt den verschraubten Probenhalter aus der Blickrichtung schräg von oben auf das Fenster 6. Figur 1 c zeigt den Probenhalter aus der Blickrichtung schräg von unten auf die Probe 3.

Mit diesem Ausführungsbeispiel wurde das Substrat in den Versuchen der Erfinder in oxidierender Atmosphäre von 0,1 mbar Sauerstoffpartialdruck auf Temperaturen bis zu 1250 °C gebracht. Anschließend wurde mittels PLD eine 200 nm dicke Schicht aufgebracht. Der Prozess dauerte insgesamt ca. 1 h. Sowohl alle Komponenten des Probenhalters als auch die Probe selbst waren nach dem Prozess intakt und weiter verwendbar.

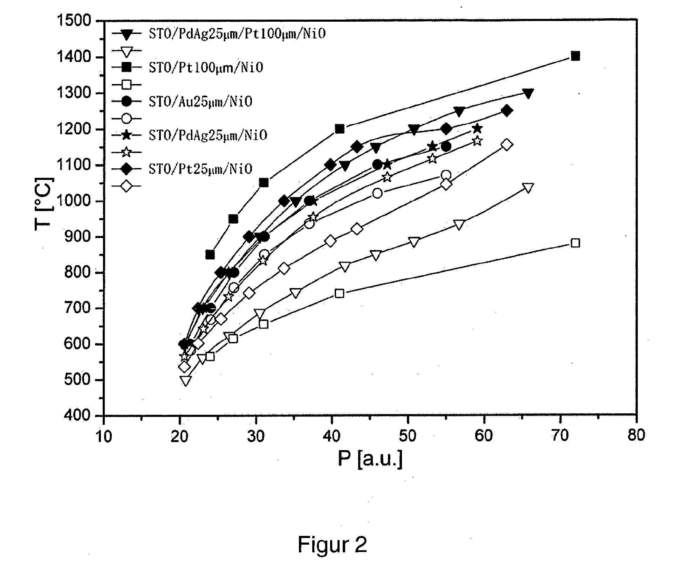

Figur 2 gibt einen Überblick über die Versuche der Erfinder. Für verschiedene als Wärmebrücke 4 verwendete Materialien sind jeweils die Temperaturen T, die der Absorber 5 und die Probe 3 erreicht haben, in Abhängigkeit der eingestrahlten Laserleistung P aufgetragen. Je näher die Kurven für eine Wärmebrücke beieinander liegen, desto weniger Wärme geht auf dem Weg vom Absorber zur Probe verloren und desto effektiver ist die Wärmebrücke. Ausgefüllte Symbole stehen für die Temperatur des Absorbers, offene Symbole für die Temperatur der SrTiO₃-Probenoberfläche. Getestet wurden
● eine dicke einfache Pt-Schicht (100µm dick),
● eine dünne einfache Pt-Schicht (25µm dick),
● eine einfache PdAg-Schicht (25µm dick)
● eine einfache PdAg-Schicht (25µm dick) mit darauf aufgebrachter Pt-Schicht (100um dick) und
● eine einfache Au-Schicht (25µm).

Am effektivsten ist die einfache PdAg-Schicht, am ineffektivsten die dicke einfache Pt-Schicht.

## Patentansprüche

1. Probenhalter zum Aufheizen einer Probe durch Strahlung aus einer Strahlungsquelle, umfassend einen auf der Rückseite der Probe anzuordnenden Absorber für die Strahlung, eine zwischen dem Absorber und der Probe anzuordnende metallische Wärmebrücke und Mittel zur Ausübung einer Normalkraft auf die Stapelung aus Probe, Wärmebrücke und Absorber,
**dadurch gekennzeichnet, dass**
der Probenhalter einen Rahmen mit einer Aussparung für die Probe umfasst, wobei eine Mehrzahl von Vorsprüngen als Auflagepunkte für die Vorderseite der Probe in das Profil der Aussparung hineinragen, und dass Mittel zur Ausübung einer Normalkraft zwischen dem Absorber und dem Rahmen vorgesehen sind.

2. Probenhalter nach Anspruch 1, **dadurch gekennzeichnet, dass** das Profil der Aussparung eine Bewegung der Probe infolge der durch das Aufheizen bewirkten thermischen Ausdehnung zulässt.

3. Probenhalter nach Anspruch 2, **dadurch gekennzeichnet, dass** das Profil der Aussparung rechteckig und in den Ecken jeweils über das Rechteck hinaus fortgesetzt ist.

4. Probenhalter nach einem der Ansprüche 2 bis 3, **dadurch gekennzeichnet, dass** weitere Vorsprünge zur Führung der Kanten der Probe in das Profil der Aussparung hineinragen.

5. Probenhalter nach einem der Ansprüche 1 bis 4, **dadurch gekennzeichnet, dass** ein zweiter Rahmen vorgesehen ist, dessen Randbereich die Normalkraft auf den Absorber auszuüben vermag und durch dessen Inneres der Laserstrahl auf den Absorber eingestrahlt werden kann.

6. Probenhalter nach Anspruch 5, **gekennzeichnet durch** Mittel zur Ausübung eines Pressdrucks der beiden Rahmen gegeneinander.

7. Probenhalter nach einem der Ansprüche 1 bis 6, **dadurch gekennzeichnet, dass** auf der der Probe abgewandten Seite des Absorbers ein für den Laserstrahl transparentes Fenster angeordnet ist.

8. Probenhalter nach einem der Ansprüche 1 bis 7, **dadurch gekennzeichnet, dass** der oder die Rahmen aus einer metallischen Legierung bestehen, die bei Temperaturen oberhalb von 800 °C eine keramische Oxidschicht an ihrer Oberfläche auszubilden vermag.

9. Probenhalter nach Anspruch 8, **dadurch gekennzeichnet, dass** die metallische Legierung Aluminium und/oder Zirkon enthält.
